(19) Europäisches Patentamt
European Patent Office
Office européen des brevets

(11) EP 4 379 772 A1

(12) EUROPEAN PATENT APPLICATION
published in accordance with Art. 153(4) EPC

(43) Date of publication:
05.06.2024 Bulletin 2024/23

(21) Application number: 22861745.2

(22) Date of filing: 25.08.2022

(51) International Patent Classification (IPC):
H01L /(2006.01)

(52) Cooperative Patent Classification (CPC):
C04B 35/447; C04B 35/547; C23C 14/06;
C23C 16/30; Y02E 40/60

(86) International application number:
PCT/KR2022/012774

(87) International publication number:
WO 2023/027537 (02.03.2023 Gazette 2023/09)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 25.08.2021 KR 20220106812

(71) Applicant: Quantum Energy Research Centre
(Q-Centre)
Seoul 05822 (KR)

(72) Inventors:
• LEE, Suk-Bae
Seoul 05822 (KR)
• KIM, Ji Hoon
Seoul 01487 (KR)
• KWON, Young-Wan
Seoul 02831 (KR)

(74) Representative: RGTH
Patentanwälte PartGmbB
Neuer Wall 10
20354 Hamburg (DE)

(54) ROOM-TEMPERATURE AND ATMOSPHERIC-PRESSURE SUPERCONDUCTING CERAMIC COMPOUND AND PREPARATION METHOD THEREFOR

(57) Disclosed are a room-temperature and ambient-pressure superconducting ceramic and methods for producing the same. The superconducting ceramic is represented by Formula 1: $A_{10-x}B_x(PO_4)_6O$ wherein $A$ is Ca, Ba, Sr, Sn or Pb, $B$ is Cu, Cd, Zn, Mn, Fe, Ni or Ag, and $x$ is 0.1 to 2.0. The superconducting ceramic exhibits superconductivity at room temperature and ambient pressure. The methods are suitable for producing the superconducting ceramic.

[Fig. 1]

EP 4 379 772 A1

**Description**

**Technical Field**

The present invention relates to a room-temperature and ambient-pressure superconducting ceramic and methods for producing the same. More specifically, the present invention relates to a superconducting ceramic that exhibits superconductivity at room temperature and ambient pressure and methods for producing the superconducting ceramic.

**Background Art**

Tremendous technological advances have been made in dealing with electrons, to the point where the modern world is called the age of electricity and electronics. The underlying aspect for modern technological advances, of course, lies in sufficient supply of power based on electricity generation, transmission, and distribution. The sufficient supply of power has brought about the development of primary and secondary batteries as power storage media and even wireless power transmission and reception technology and is thus considered a driving force to achieve huge modern developments.

The use of low resistance materials such as copper and gold offers an alternative to solve recently emerging environmental and energy issues and a fundamental solution to the problems (for example, low efficiency) encountered in the high integration/densification of semiconductors. Thus, there is a need to find new materials that can replace low resistance materials while avoiding the problems of the prior art.

Recently, high-temperature superconductors have attracted attention as replacements for low resistance materials. The publication of a new class of superconducting materials with a critical temperature (Tc) above the upper limit of the critical temperature predicted by Bednorz and Muller and the classical BCS theory in 1986 (Bednorz, et al, ZPhys B 64, 189 (1986)) surprised the solid-state physics community.

These materials are ceramics consisting of copper oxide layers separated by buffer cations. In the Bednorz and Muller's original material (LBCO), the buffer cations are lanthanum and barium ions. Their work has inspired Paul Chu to synthesize a similar material containing yttrium and barium ions as buffer ions.

This material is YBCO, the first superconductor with a Tc exceeding the boiling point of liquid nitrogen (77 K) (Wu, et al, Phys Rev Lett 58, 908 (1987)).

According to a report that marked a similar milestone, hydrogen sulfide shows the highest critical temperature of 203.5 K at a pressure of 155 GPa (Conventional superconductivity at 203 kelvin at high pressures in the sulfur hydride system. Nature 525, 73 (2015)).

Even afterwards, related studies have been conducted using similar materials. The critical temperature of recent superconducting materials has been reported to be continuously increasing. For example, a superconducting material reported in 2020 has a critical temperature of 15 °C close to room temperature but requires a very high pressure of 267 GPa. As a result of repeated efforts to lower the required pressure, a material exhibiting superconductivity at about -5 °C and an applied pressure of 186 GPa was reported in 2021. However, the temperature and pressure conditions seem to make it difficult to apply the material to daily life (https://en.Wikipedia.org/wiki/Room-temperature_superconductor).

Despite the fact that the experimental results for the hydrogen sulfide and yttrium superhydride superconducting materials create high expectations for room-temperature superconductors in the academic community, the very high pressures 267 GPa and 186 GPa correspond to approximately 200,000 times higher than the atmospheric pressure (1 atm), making the superconducting materials substantially impossible to apply to industrial fields. Particularly, 267 GPa is converted into more than 2,700 tons applied to an area of 1 cm$^2$.

Thus, there is a need to develop superconducting materials that can be used not only at room temperature but also ambient pressure. Superconducting materials other than hydrogen sulfide or yttrium superhydride-based materials that do not require high pressure are considered highly applicable across all industries.

A material containing a small amount of a room-temperature and ambient-pressure superconductor with a critical temperature of 313 K is disclosed in a patent application filed by the present applicant. The presence of the superconductor was identified by analyzing the magnetic properties of the material and MAMMA but the amount of the superconductor in the material is not sufficient to identify electrical properties unique to superconductors.

**Detailed Description of the Invention**

**Problems to be Solved by the Invention**

A first object of the present invention is to provide a superconducting ceramic that exhibits superconductivity at room temperature and ambient pressure.

A second object of the present invention is to provide a method for producing a superconducting ceramic that exhibits superconductivity at room temperature and ambient pressure.

A third object of the present invention is to provide a solid-phase method for producing a superconducting ceramic that exhibits superconductivity at room temperature and ambient pressure.

**Means for Solving the Problems**

One aspect of the present invention provides a superconducting ceramic represented by Formula 1:

<Formula 1> $A_{10-x}B_x(PO_4)_6O$

wherein **A** is Ca, Ba, Sr, Sn or Pb, **B** is Cu, Cd, Zn, Mn, Fe, Ni or Ag, and **x** is 0.1 to 2.0.

According to one embodiment of the present invention, in Formula 1, **B** may substitute **A.**

According to a further embodiment of the present invention, other **A** positions may be changed by **B.**

According to another embodiment of the present invention, the lattice structure of the ceramic material may be modified by the substitution of **B.**

According to another embodiment of the present invention, superconducting quantum wells (SQWs) may be formed between **A** and $(PO_4)_6$.

According to another embodiment of the present invention, the superconducting quantum wells (SQWs) may be formed at 3.7 to 6.5 Å intervals.

According to another embodiment of the present invention, tunneling may occur between the superconducting quantum wells (SQWs).

According to still another embodiment of the present invention, the substitution of **B** may increase the strength and hardness of the ceramic material, leading to less change in heat capacity.

A further aspect of the present invention provides a method for producing a superconducting ceramic represented by Formula 1:

<Formula 1> $A_{10-x}B_x(PO_4)_6O$

wherein **A** is Ca, Ba, Sr, Sn or Pb, **B** is Cu, Cd, Zn, Mn, Fe, Ni or Ag, and **x** is 0.1 to 2.0, the method including depositing raw materials.

According to one embodiment of the present invention, the deposition may be performed at a reaction temperature of 550 to 2000 °C.

Another aspect of the present invention provides a method for producing a superconducting ceramic represented by Formula 1:

<Formula 1> $A_{10-x}B_x(PO_4)_6O$

wherein **A** is Ca, Ba, Sr, Sn or Pb, **B** is Cu, Cd, Zn, Mn, Fe, Ni or Ag, and **x** is 0.1 to 2.0, the method including reacting lanarkite (L, $Pb_2SO_5$=PbO·$PbSO_4$) with copper phosphide ($Cu_3P$).

According to one embodiment of the present invention, the reaction may be carried out at a temperature of 600 to 1000 °C.

According to a further embodiment of the present invention, the lanarkite may be prepared by weighing PbO and $PbSO_4$ to have its composition, mixing the weighed raw materials, and heating the mixture.

According to another embodiment of the present invention, the CusP may be synthesized by weighing Cu and P to have its composition, mixing the weighed raw materials, and heating the mixture.

Yet another aspect of the present invention provides a superconducting ceramic produced by any of the methods described herein.

According to one embodiment of the present invention, the diamagnetism of the ceramic material may be determined by the temperature-dependent magnetic susceptibility of the ceramic material.

According to a further embodiment of the present invention, the diamagnetism or ferromagnetism of the ceramic material may be determined by the magnetic field-dependent magnetic susceptibility of the ceramic material.

According to another embodiment of the present invention, the temperature-dependent current-voltage characteristics of the ceramic material may not follow the Ohm's law (V = I×R where V: voltage, I: current, and R: resistance).

According to another embodiment of the present invention, the current-voltage characteristics of the ceramic material may optionally depend on a magnetic field (V = I×R or V ≠ I×R).

According to another embodiment of the present invention, the resistance-temperature characteristics of the ceramic material may follow the Ohm's law above the transition temperature of the ceramic material.

According to still another embodiment of the present invention, the heat capacity of the ceramic material may not follow the law of heat capacity change by a Debye model.

**Effects of the Invention**

The superconducting ceramic of the present invention exhibits superconductivity at room temperature and ambient pressure. The methods of the present invention are suitable for producing the superconducting ceramic.

**Brief Description of the Drawings**

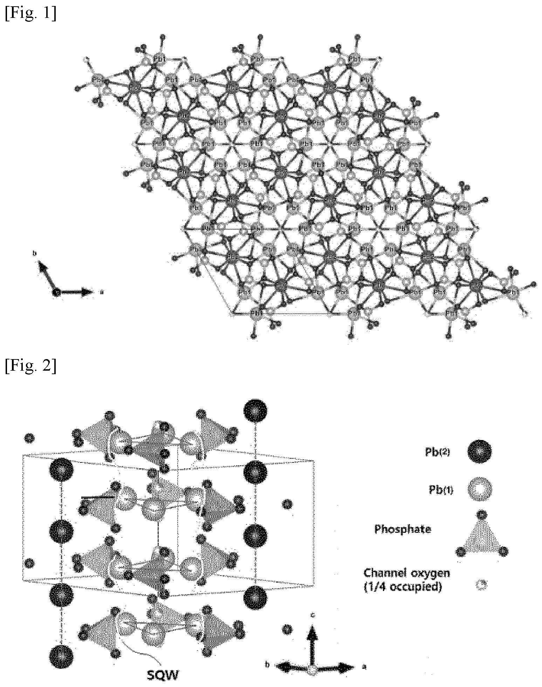

Figs. 1 and 2 are diagrams schematically showing the structure of a ceramic material according to the present invention, where **A** and **B** represent Pb and Cu, respectively. Specifically, Fig. 1 shows the structure and unit cells of a ceramic material according to the present invention when viewed from the c-axis direction orthogonal to the a-b plane in a Cartesian coordinate system representing a space and Fig. 2 is a diagram showing the structure of one of the unit cells shown in Fig. 1 along the c-axis perpendicular to the a-b plane, in which the unit structure of the ceramic material is indicated by the solid line box and positions where superconducting quantum wells (SQWs) are created are shown.

Fig. 3 is a diagram schematically showing the structure of a ceramic material according to the present invention in which **A** ions (Pb(II) ions) are substituted with **B** ions (Cu(II) ions) at the polyhedral Pb(2) sites and the occurrence of volume shrinkage and stress due to the substituted copper ions.

Fig. 4 is a band diagram showing the superconducting quantum well (SQW) generated between Pb(1) and oxygens of phosphate by structural distortion in Fig. 2.

Fig. 5 is a photograph showing a sample of gray-black colored LK-99 according to the present invention.

Figs. 6 and 7 show the measured voltage vs. applied current at temperatures of 298 to 398 K in a sample of a ceramic material produced in Example 1 and the zero resistivity of the sample, respectively, in which the unit of the vertical axis of the inset is $\times 10^{-9}$.

Figs. 8 and 9 show the external magnetic field (H) dependence of applied current in a sample prepared in Example 2 and zero field cooling, respectively.

Figs. 10 and 11 show the correlation between the critical current and the critical magnetic field and the correlation between the critical current and the critical temperature in a sample prepared in Example 2, respectively.

Fig. 12 shows the results of XRD for a sample prepared in Example 2.

Fig. 13 shows an EPR signal of LK-99 according to the present invention.

Fig. 14 shows an EPR signal of LK-99 after I-V measurement.

Fig. 15 shows calculated Debye temperatures from heat capacity data.

Fig. 16 shows heat capacity curves of LK-99 according to the present invention.

Figs. 17 and 18 show ferromagnetic behaviors of a sample prepared in Example 2, which were measured with SQUID in VSM mode at 300 K.

Fig. 19 shows the Meissner effect (around 0 Oe, $< \pm 100$ Oe) and ferromagnetic ($< \pm 500$ Oe) and diamagnetic ($> \pm 500$ Oe) behaviors of a sample prepared in Example 2, which were determined by DC magnetic field measurements at 100 K.

Fig. 20 shows absorption signals of a sample prepared in Example 2 in electron spin resonance measurements.

Figs. 21 and 22 are photographs showing magnetic levitation of a sample prepared in Example 2. Specifically, Fig. 21 shows a state in which an LK-99 sample was simply placed on a magnet because the phenomenon of magnetic levitation did not occur well when no current was supplied to the LK-99 sample, resulting in very small diamagnetism and Fig. 22 shows the occurrence of the phenomenon of magnetic levitation of the sample due to the increased number of Cooper pairs generated when current was supplied to the sample, resulting in enhanced diamagnetism.

**Mode for Carrying out the Invention**

The present invention will now be described in detail.

Technical terms used herein are used to merely illustrate specific embodiments and should be understood that they are not intended to limit the present invention.

As far as not being defined differently, technical terms used herein may have the same meaning as those generally understood by an ordinary person skilled in the art to which the present invention belongs, and should not be construed in an excessively comprehensive meaning or an excessively restricted meaning. If a technical term used herein is an erroneous term that fails to clearly express the idea of the present invention, it should be replaced by a technical term that can be properly understood by the skilled person in the art. In addition, general terms used herein should be construed according to definitions in dictionaries or according to its front or rear context and should not be construed in an excessively restricted meaning. As used herein, the singular forms "a," "an" and "the" are intended to include the plural forms as well, unless the context clearly indicates otherwise. The terms "comprises", "comprising", "includes" and/or "including" as used herein should not be construed to necessarily include all of the elements or steps disclosed herein, and should be construed not to include some of the elements or steps thereof, or should be construed to further include additional elements or steps. In the description of the present invention, detailed explanations of related art are omitted when it is deemed that they may unnecessarily obscure the essence of the invention.

The present invention is intended to disclose a crystal structure of a superconducting material present in a small amount, which is not disclosed in the previously filed patent application.

The present inventors have found a way to increase the amount of a superconducting material in the form of a thin film through vapor deposition (VD). The present inventors have also found a reaction mechanism and a crystal structure of the superconducting material through additional analysis. Based on these findings, the present inventors have succeeded in synthesizing the superconducting material in the form of an ingot or powder through a typical solid-state reaction.

The deposition process may be chemical vapor deposition using heat as an energy source and is not limited thereto. Any deposition process for depositing raw materials may be used without limitation. Examples of suitable deposition processes include atomic layer deposition (ALD), sputtering, thermal evaporation, e-beam evaporation, molecular beam epitaxy (MBE), and pulsed laser deposition (PLD).

A superconducting ceramic of the present invention is represented by Formula 1.

$$<\text{Formula 1}> \quad A_{10-x}B_x(PO_4)_6O$$

wherein **A** is Ca, Ba, Sr, Sn or Pb, **B** is Cu, Cd, Zn, Mn, Fe, Ni or Ag, and **x** is 0.1 to 2.0.

The ceramic material of Formula 1 and apatite have different physical properties and characteristics despite their structural similarity. The structure of the ceramic material of Formula 1 is herein referred to as "LK99".

Apatite is a mineral in which metal atoms are bonded to phosphate groups. Apatite has long been commonly used as a dye. Apatite is an electrical insulator with a large energy gap, while LK99 acts as an electrical conductor (particularly a superconductor) because it contains substituents or dopants and defects capable of creating a new energy level.

More specifically, **A** in Formula 1 is Ca, Ba, Sr, Sn or Pb that has the characteristics of an s- or p-block metal, Y, La or Ce as an element of the lanthanide series or a combination thereof.

**B** in Formula 1 is Cu, Cd, Zn, Mn, Fe, Ni or Ag that has the characteristics of a d-block metal or a combination thereof. **B** in Formula 1 is an element with d-orbitals as a kind of substituent or dopant and enables conversion from an insulator to a conductor or superconductor.

**x** in Formula 1 is preferably 0.1 to 2.0. If **x** is less than 0.1, the structure of the ceramic material may be spatially distorted or negligible intergrain stress may be caused by distortion, failing to form superconducting quantum wells (SQW). Meanwhile, if **x** exceeds 2.0, the desired material may not be obtained or an unstable lattice or a different form of lattice may be formed.

Figs. 1 and 2 are diagrams schematically showing the structure of the ceramic material according to the present invention, where **A** and **B** represent Pb and Cu, respectively. Specifically, Fig. 1 shows the structure and unit cells of the ceramic material according to the present invention when viewed from the c-axis direction orthogonal to the a-b plane in a Cartesian coordinate system representing a space and Fig. 2 is a diagram showing the structure of one of the unit cells shown in Fig. 1 along the c-axis perpendicular to the a-b plane. In Fig. 2, the unit structure of the ceramic material is indicated by the solid line box and positions where superconducting quantum wells (SQWs) are created are shown.

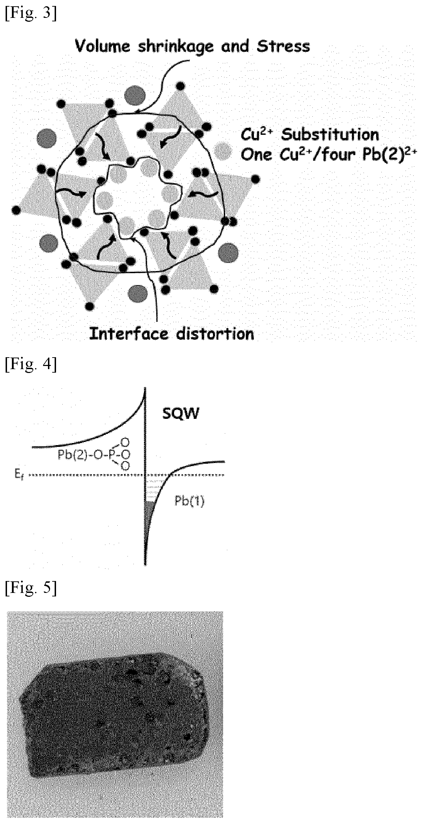

Fig. 3 is a diagram schematically showing the structure of the ceramic material according to the present invention in which **A** ions (Pb(II) ions) are substituted with **B** ions (Cu(II) ions) at the polyhedral Pb(2) sites and the occurrence of volume shrinkage and stress due to the substituted copper ions and Fig. 4 is a band diagram showing the superconducting quantum well (SQW) generated between Pb(1) and oxygens of phosphate by structural distortion in Fig. 2.

In Formula 1, six **A** ions (Pb(1) ions) and channel oxygen (O) make a polyhedral structure. That is, three **A** ions are planarly arranged in a triangular shape and three other **A** ions are planarly stacked in a triangular shape thereon or thereunder wherein the two triangles are arranged in a staggered manner rather than overlapping each other, and phosphate ($(PO_4)_6$) is arranged adjacent to each **A**.

For example, when **A** is Pb, the polyhedral structure is composed of asymmetric polyhedral six Pb(1)-O components arranged continuously up and down in the unit cell to form a polygonal or cylindrical column in the entire solid structure.

More specifically, six Pb(1) ions are grouped in threes and form a total of two layers around four sites where channel oxygen (O) located at the centers of triangles consisting of Pb(1) may exist.

When the unit cells are continuous, channel oxygen (O) randomly occupies one of the four sites. The Pb(1)-O layers formed in the unit cell are connected in the c-axis direction to form a cylindrical column surrounded by a three-dimensional structure composed of Pb(2)-O-P.

In summary, LK-99 of the present invention has a three-dimensional network structure as a whole and a cylindrical column surrounded by an insulating tetrahedral $PO_4$ network structure. Asymmetric polyhedral Pb(1)-O components are arranged in the surrounded cylindrical column. The asymmetric polyhedral six Pb(1)-O components form two overlying and underlying triangles (each consisting of three Pb(1) ions) arranged in a staggered manner.

**B** (Cu) substitutes **A**. Specifically, **B** (Cu) ion replaces four **A** (Pb(2)) ions arranged in the shell of the polygonal or cylindrical column rather than substituting **A** (Pb(1)) forming the polyhedron. Pb(2) is distinguished from Pb(1) that forms the internal columnar structure.

That is, the polyhedral four Pb(2) ions are arranged in the insulating tetrahedral $PO_4$ network structure of LK-99 and approximately one of the four Pb(2) ions is substituted with one copper ion ($Cu^{2+}$). As a result, the position of Pb(1) is slightly shifted from the original position (before substitution) by the substitution of copper ions. Similarly to the diagram shown in Fig. 3, the substituted copper ions cause volume shrinkage and stress in the insulating tetrahedral $PO_4$ network structure. Due to this influence, the arrangement of Pb(1) ions in the internal polygonal or cylindrical column is distorted, resulting in distortion at the interface between the insulating tetrahedral $PO_4$ network structure and the polygonal or cylindrical column. This distortion can be understood to lead to the formation of superconducting quantum wells (SQWs).

The substitution of copper ions in LK-99 results in a volume reduction of 0.48% because the size of copper ions ($Cu^{2+}$, 87 pm) is smaller than that of lead ions ($Pb^{2+}$, 133 pm). This volume reduction causes stress, finally affecting the expression of superconductivity.

In LK-99, the ratio of copper is determined based on the atomic % data of XPS and confirmed by the Debye heat capacity model, which will be described in more detail below.

Each atomic % of XPS can be calculated by summing the areas under the binding energy peaks of the corresponding atom, dividing the sum by the total number of electrons occupying the measured orbitals of the atom, and multiplying the result by the relative sensitivity of the atom to XPS to determine the amount or intensity of the atom. The ratio of copper can be determined by calculating the relative amounts of Pb and Cu. When the value of Pb is set to be 10 based on XPS measurement data, the value of Cu can be calculated to be about 0.9.

The ceramic material (LK-99) of the present invention is gray or black in color (Fig. 5), which is contrasted with ivory apatite. LK-99 is a superconductor, unlike insulating apatite.

According to the present invention, the arrangement of **A** is changed by the substitution of **B** so that the strength and hardness of the ceramic material are increased, resulting in less change in heat capacity. The reason is that **A** ($Pb^{2+}$) is smaller in size and volume than the substituted **B** ($Cu^{2+}$), resulting in an overall volume shrinkage.

That is, the substitution of **B** modifies the molecular structure, which limits the normal three-dimensional vibrational movement, resulting in less change in heat capacity.

If electrons are moved by tunneling between superconducting quantum wells (SQWs) of the ceramic material according to the present invention, the resistance will be zero. This is similar to the well-known Josephson effect in which even when an insulator is interposed between superconductors, tunneling through which current flows is discovered.

Tunneling between superconducting quantum wells (SQWs) is likely to be possible, as SQWs are expected to be formed at 3.7 Å to 6.5 Å intervals in LK-99. This tunneling is made possible when electrons with two oppositely charged spins combine to form a Cooper pair. The electrons of the Cooper pair greatly reduce the Coulomb attraction with the nuclei of neighboring atoms, and as a result, they can easily pass through barriers. In addition, the sum of kinetic energy required for tunneling, kinetic energy by electron-electron interaction between the Cooper pairs, and kinetic energy of the two electrons of the Cooper pairs appears to act as an energy source that has the potential to tunnel between SQWs.

Since LK-99 of the present invention has SQWs between the Pb(1) of the internal column and the external insulating tetrahedral $PO_4$ network structure, the applied current seems to be transported through the SQWs of the cylindrical column via the tunneling process. It appears that the SQWs are partially filled and the transported electrons undergo pairing (Cooper pairing), condensation, etc.

LK-99 of the present invention exhibits superconductivity at room temperature and ambient pressure because the stress generated by the substitution of **B** ($Cu^{2+}$) is transferred to the interface of the cylindrical column without being relieved.

In other words, the Pb(1) atoms in the polygonal (or cylindrical) column interface occupy a structurally limited space. These interfacial atoms are entirely affected by the stress and strain generated by the substituted **B,** for example, copper ions ($Cu^{2+}$). Since this distortion can be maintained even at room temperature and ambient pressure, SQWs can be generated (without a relaxation to relieve the distortion such that the ceramic material returns to its original state), achieving the expression of superconductivity.

The present invention also provides a method for producing a ceramic material represented by Formula 1:

<Formula 1>        $A_{10-x}B_x(PO_4)_6O$

wherein **A** is Ca, Ba, Sr, Sn or Pb, **B** is Cu, Cd, Zn, Mn, Fe, Ni or Ag, and **x** is 0.1 to 2.0, the method including depositing raw materials.

The ceramic material represented by Formula 1 can be synthesized by weighing raw materials for $A_{10-x}B_x(PO_4)_6O$ (Formula 1) in the predetermined molar ratio and allowing the raw materials to react in a vacuum-controlled reaction vessel at a temperature of 550 to 2000 °C for 1 to 100 hours for vapor deposition.

The raw materials may be pretreated for effective, dense and uniform vapor deposition. This pretreatment is performed by weighing raw materials for $A_{10-x}B_x(PO_4)_6O$ (Formula 1) in the predetermined molar ratio and allowing the raw materials to react in a vacuum-controlled reaction vessel at a temperature of 550 to 1100 °C for 1 to 100 hours. The resulting ceramic precursor can be used as a raw material for deposition.

In the present invention, the deposition process may be thermal vapor deposition (TVD), which is a form of physical vapor deposition (PVD). In this case, the processing temperature and time conditions are set to (1) 550-1100 °C and 10-100 hours for the synthesis of the ceramic precursor and (2) 550-2000 °C and 0.001-100 hours for the subsequent vapor deposition.

The reason for these conditions is that stable reaction conditions (including a relatively low temperature (550-1100 °C)) are primarily established depending on the desired composition to allow the reaction to proceed in a well-mixed solid solution and the resulting ceramic precursor is used as a raw material for the subsequent vapor deposition.

If the heating temperature for the synthesis of the ceramic precursor is lower than 550 °C, sufficient mixing may not take place, with the result that the desired reaction does not occur sufficiently. Meanwhile, if the heating temperature exceeds 1100 °C, the composition may be changed and other reactions may occur, making it impossible to obtain the desired composition and causing a waste of energy. If the heating time is shorter than 10 hours, the desired reaction does not occur sufficiently, like when the heating temperature is low. Meanwhile, if the heating time exceeds 100 hours, too much energy may be consumed.

The deposition may be carried out by two processes: physical vapor deposition (PVD) and chemical vapor deposition (CVD) depending on the deposition conditions. Physical vapor deposition includes thermal evaporation at 550 to 2000 °C. If the deposition temperature is lower than 550 °C, the elements may not be sufficiently vaporized, making it difficult to uniformly produce the final material. Meanwhile, if the deposition temperature exceeds 2000 °C, the superconducting material may be difficult to produce. If the heating time is shorter than 0.001 hours, the raw materials may not be sufficiently vaporized, leading to a small deposition thickness. Meanwhile, if the heating time exceeds 100 hours, energy may be wasted after completion of the deposition.

According to chemical vapor deposition (CVD), a well-prepared sample (including the pretreated material) is placed on a heating element under vacuum and is vaporized by heating with an energy source. If the heating temperature is lower than 550 °C, the raw materials needing to be gassed are hardly vaporized. Meanwhile, if the heating temperature exceeds 2000 °C, the temperature of the deposition surface may rise excessively, making it difficult to form the desired deposition phase. If the heating time is shorter than 0.001 hours, the raw materials may not be sufficiently vaporized, leading to a small deposition thickness. Meanwhile, if the heating time exceeds 100 hours, energy may be wasted after completion of the deposition.

For chemical vapor deposition (CVD), it is believed that evaporated PbS primarily reacts with oxygen from a substrate to form lanarkite, as depicted below:

<Reaction scheme 1>        $2PbS\ (s) + 5/2O_2\ (s,\ \text{from substrate}) \rightarrow Pb_2SO_5\ (s) + S\ (g)\uparrow$

Thereafter, Cu and P substitute Pb and S of the lanarkite ($Pb_2SO_5 = PbO \cdot PbSO_4$), respectively, to produce the superconducting ceramic (LK-99) of the present invention.

This can be drawn from the following inferences: (1) the superconducting material is produced where lanarkite is present; (2) both Cu and P are detected in the superconducting material; (3) Cu and P form CusP, which is found in the database (COD); and (4) therefore, the reaction of lanarkite with $Cu_3P$ leads to the production of 'LK99', which is the structure of the superconducting ceramic according to the present invention. This reaction is depicted below:

<Reaction scheme 2>        **L + $Cu_3P \rightarrow$ LK99**

where L represents lanarkite ($Pb_2SO_5 = PbO \cdot PbSO_4$).

The reaction scheme explains the mechanism of the reaction for producing the ceramic material of the present invention. The structure of apatite does not have only sulfate groups but has only phosphate groups or both phosphate and sulfate groups. Lanarkite is a sulfate compound. When lanarkite reacts with CusP, some or all of the sulfur atoms are replaced with phosphorus atoms to form phosphate groups.

The reaction for the synthesis of the ceramic material according to the present invention is a solid-state reaction. Specifically, the ceramic material of the present invention is synthesized by the following procedure.

First, a PbO powder is homogenized with a $PbSO_4$ powder in a 1:1 molar ratio, the mixture is placed in an alumina crucible and put in a furnace, and the reaction is allowed to proceed at 725 °C for 24 hours to synthesize lanarkite. After completion of the reaction, the lanarkite is ground and stored in a vial.

Next, a Cu powder is homogenized with a P powder in the predetermined ratio, the mixture is placed in a quartz tube as a reaction tube, the reaction tube is evacuated and sealed, and the reaction is allowed to proceed at 550 °C for 48 hours to prepare CusP. After completion of the reaction, the reaction product is taken out of the tube and the resulting ingot is ground and stored in a vial.

Next, the lanarkite is homogenized with the CusP in a 1:1 molar ratio, the mixture is placed in a reaction tube, the reaction tube is evacuated and sealed, and the reaction is allowed to proceed at 600 to 1000 °C for 5 to 40 hours to prepare the ceramic material of the present invention. If the reaction temperature is lower than 600 °C, sufficient reaction energy is not supplied. Meanwhile, if the reaction temperature exceeds 1000 °C, $SO_4$ present in the lanarkite may be decomposed. If the reaction time is shorter than 5 hours, large amounts of the materials may remain unreacted. Meanwhile, if the reaction time is longer than 40 hours, no particular effect is expected because the reaction is already completed. After completion of the reaction, the reaction product is taken out of the tube and used as a sample. The resulting ingot may be processed or ground and stored, as needed.

Example 1 - Synthesis by vapor deposition

The following procedure was carried out to synthesize the inventive ceramic material represented by $A_{10-x}B_x(PO_4)_6O$ (Formula 1) wherein **A** is Pb and **B** is Cu, *i.e.* $Pb_{10-x}Cu_x(PO_4)_6O$ (Formula 2) wherein **x** is 0.1 to 2.0. First, Pb, Cu, and P were weighed in the predetermined molar ratio to a total of 3 g. The mixture was placed in a quartz tube. The quartz tube was evacuated to $10^{-5}$ Torr with a vacuum pump. The vacuum was maintained for 20 min. Thereafter, the tube was allowed to extend a total length of 15 cm, sealed with a torch, and put in a furnace chamber. The mixture was allowed to react at a temperature of 550-1100 °C for a time of 10-100 h to synthesize a ceramic precursor. The ceramic precursor was loaded as a raw material on a substrate, arranged in a vacuum chamber, placed on a tungsten boat as a heating element, liquefied while maintaining a vacuum of $\leq 10^{-5}$ Torr and the temperature of the heating element at ~550-900 °C for ~1-5 min, heated to 900-2000 °C, and vaporized for deposition on the surface of a high-purity glass plate arranged in the path of an ascending gas.

Example 2 - Synthesis by solid-state reaction

A PbO powder was homogenized with a $PbSO_4$ powder in a 1:1 molar ratio, the mixture was placed in an alumina crucible and put in a furnace, and the reaction was allowed to proceed at 725 °C for 24 h to synthesize lanarkite. After completion of the reaction, the lanarkite was ground. Next, a Cu powder was homogenized with a P powder in the predetermined ratio, the mixture was placed in a quartz tube as a reaction tube, the reaction tube was evacuated and sealed, and the reaction was allowed to proceed at 550 °C for 48 h to prepare CusP. After completion of the reaction, the reaction product was taken out of the tube. The resulting ingot was ground. Next, the lanarkite was homogenized with the $Cu_3P$ in a 1:1 molar ratio, the mixture was placed in a reaction tube, the reaction tube was evacuated to $10^{-5}$ Torr and sealed, and the reaction was allowed to proceed at 925 °C for 10 h to synthesize the inventive ceramic material. After completion of the reaction, the resulting ingot was taken out of the tube and used as a sample. The PbO, $PbSO_4$, Cu, and P used for the solid-state reaction were purchased from JUNSEI, KANTO, DAEJUNG, and JUNSEI, respectively. The PbO and $PbSO_4$ were GR grade and the Cu and P were EP grade.

The ingot was dark-gray colored and hard. The ingot was slightly porous due to the influence of gas molecules escaping during the synthesis reaction. The size of the sample varied depending on the size of the reaction vessel and the amounts of the reactants. The ingot was processed into a thin rectangular parallelepiped plate for electrical resistance measurement. The ingot was ground for XRD, SQUID, and EPR measurements. The powder was pelletized for XPS measurement.

Experimental Example 1 - Measurement of electrical properties

The ingot obtained in Example 1 was processed into a thin rectangular parallelepiped plate and used as a sample. The electrical properties of the sample were measured by a 4-probe method using probes arrayed with the same distance (1.2 mm). The Keithley 228A and Keithley 182 were used as voltage/current source and sensitive digital voltmeter, respectively. For accurate temperature control and measurement, a self-designed heating device with a thermally insulated aluminum mounting plate and halogen lamp was developed and used as a heating source. A self-developed software, using LabView software, was also used for the measurement. All measuring instruments were linked with GPIB interface devices. Temperature measurement was carried out with Keithley 2000 with FLUKE 80BKDMM K-type thermocouple probe on the sample's surface.

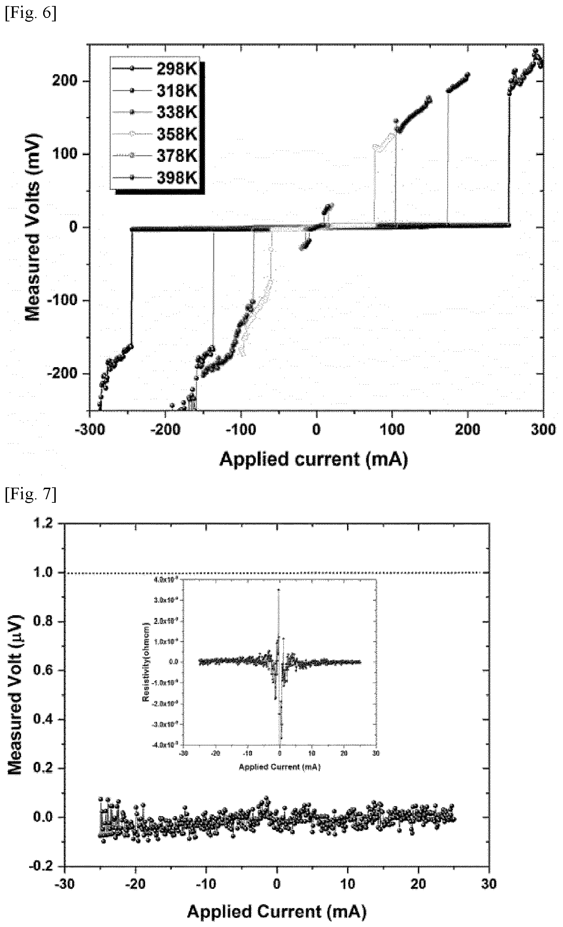

Fig. 6 shows the measured voltage vs. applied current at temperatures of 298 K to 398 K. The measurement for Fig. 6 was performed with direct current (DC) polarity change by each 20 K increment of temperature in the vacuum of 10$^{-3}$ Torr. Specific resistance was measured in the range of 10$^{-6}$ to 10$^{-9}$ $\Omega \cdot$cm.

The current-voltage characteristics of the ceramic material according to the present invention do not follow the Ohm's law when the magnitude of an external magnetic field applied is 0 G. In addition, the ceramic material of the present invention undergoes less change in voltage in response to the supplied current. The maximum amount of current flowing through the ceramic material of the present invention tends to decrease in response to the magnitude of the external magnetic field. Thereafter, the current-voltage characteristics of the ceramic material according to the present invention follows the Ohm's law above the maximum amount of current.

The superconducting phase of the ceramic material according to the present invention is broken by a change in temperature. As a result, the amount of current with zero electrical resistance decreases with increasing temperature. Eventually, due to the broken superconducting phase, the resistance-temperature characteristics of the ceramic material according to the present invention will follow the Ohm's law.

Fig. 7 shows the zero-resistivity of a thin film of LK-99, which satisfied the zero-resistivity of international standards (Y. Wang, Fundamental Elements of Applied Superconductivity in Electrical Engineering. (Wiley, 2013), J. W. Ekin, Experimental Techniques for Low-Temperature Measurements. (Oxford University Press, New York, 2006)) as a new superconductor. As shown in Fig. 7, the measured voltage was obtained in the range of 0.1 $\mu$V/cm during the applied current increasing and decreasing. The resistivity was calculated in the order of 10$^{-10}$-10$^{-11}$ $\Omega \cdot$cm. As the grain boundary is decreased, the residual resistance of the thin film decreased.

The temperature-dependent current-voltage characteristics of the ceramic material according to the present invention do not follow the Ohm's law. In addition, the ceramic material of the present invention undergoes less change in voltage in response to the supplied current. Therefore, the ceramic material of the present invention exhibits superconductivity.

Experimental Example 2 - Measurement of magnetic properties

Magnetization measurement was performed with dc mode, 30 mm scan length, 10 scans per measurement, scan time 10s by using a superconducting quantum interference device (SQUID). Zero field cooling was processed from 400 K to 200 K without external magnetic field and then the temperature was increased from 200 K to 400 K with 10 Oe magnetic field. Finally, the sample was cooled down from 400 K to 200 K with 10 Oe magnetic field. 45.814 mg of the sample prepared by grinding in Example 2 was used for this measurement.

Another magnetization measurement was performed with VSM mode from - 20,000 Oe to +20,000 Oe at 300 K. A third magnetization measurement was performed with dc mode, 30 mm scan length, 10 scans per measurement, and scan time 10s.

Zero field cooling was processed from 300 K to 100 K without external magnetic field and was then measured from 0 G to 3500 Oe, 3500 Oe to -3500 Oe, and -3500 Oe to 3500 Oe at 100 K.

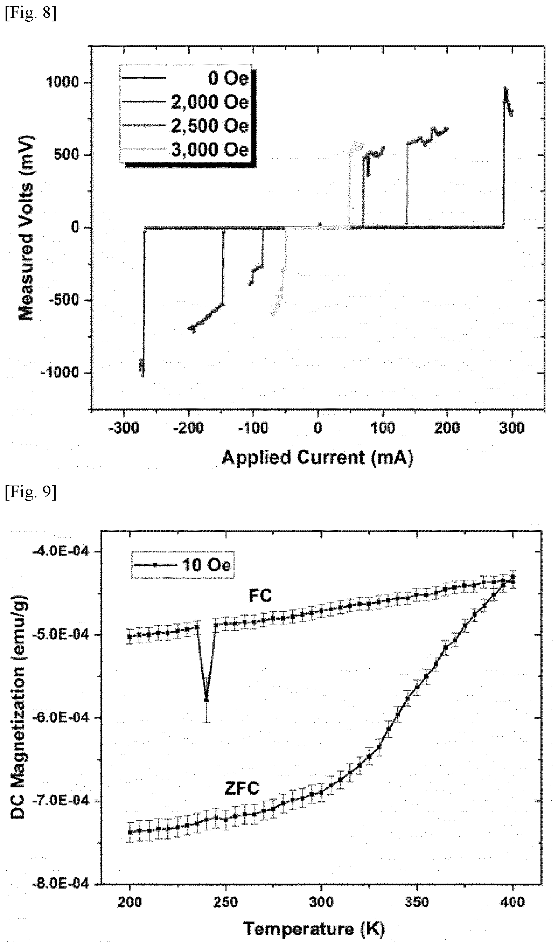

Fig. 8 shows the external magnetic field (H) dependence of applied current. Particularly, even up to 400 K, the DC magnetization value of zero field cooling and field cooling with 10 Oe was still negative in Fig. 9. These results indicate that the superconducting phase still exists under 10 Oe up to 400 K.

A transition occurs in which the magnetic susceptibility of the superconducting ceramic suddenly increases when the temperature rises above the critical temperature (Tc). This measurement is called zero field cooling (ZFC). Measurement of magnetic susceptibility with decreasing temperature is called field cooling (FC). A transition occurs in which the resistance of the superconducting ceramic suddenly decreases (theoretically drops to zero (0)) when the temperature falls below the critical temperature (Tc). The same data are obtained even when the temperature rises from a low value to 400 K or higher.

That is, when the direct current (DC) magnetic susceptibilities of the ceramic material according to the present invention were measured while raising the temperature from 200 K to 400 K and cooling from 400 K to 200 K in a magnetic field of 10 G, the values were negative (that is, diamagnetism), which is unique to superconductors.

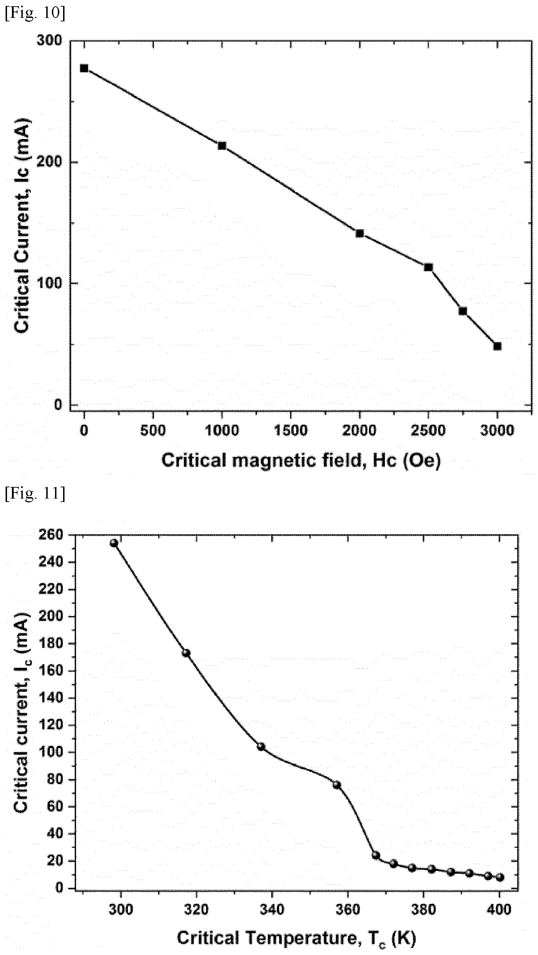

Figs. 10 and 11 show that the critical current value was not yet zero even at 400 K and 3000 Oe or more, the superconducting phase was maintained even up to 400 K, and the critical temperature was 400 K or more even at a current of less than 7 mA, failing to find a superconducting transition temperature of 400 K or less. Therefore, it can be judged that the critical temperature of LK-99 according to the present invention is over 400 K.

Experimental Example 3 - XRD measurement

The sample prepared in Example 2 was ground for XRD measurement. The measurement was performed using an XRD instrument (Rigaku (SmartLab, Japan)). The powder sample was pelletized for XPS measurement.

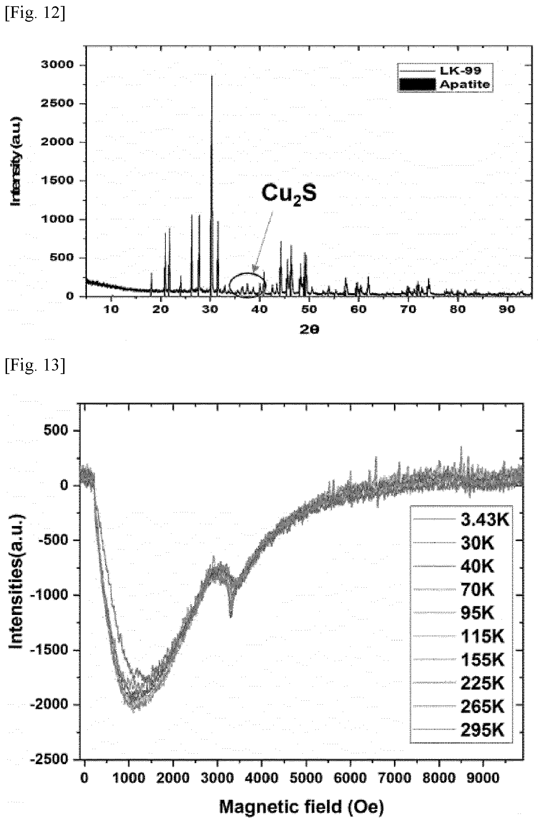

Fig. 12 shows XRD results of LK-99 matched with a reference database (Crystallography Open Database (COD)). The original XRD data was only K$\alpha$2-stripped without any other processing, considering that XRD does not use a single X-ray wavelength but uses a mixture of two wavelengths, K$\alpha$1 and K$\alpha$2, that are technically difficult to separate due to their similar energy differences. That is, any XRD peak is split into two by K$\alpha$1 and K$\alpha$2 when observed with high resolution and suitable software should be used to remove the K$\alpha$2 peak and consider only the K$\alpha$1 peak during data processing because the intensity of K$\alpha$2 is as small as about half that of K$\alpha$1.

The data obtained thus were very similar to those for apatite on the reference database.

This result shows that LK-99 of the present invention is polycrystalline. The main peaks were well matched with the lead-apatite (AP) structure and few $Cu_2S$ impurities were detected. The crystal system of the original lead-apatite is hexagonal (P6$_{3/m}$, 176) with the cell parameters a = 9.865 Å and c = 7.431 Å. However, LK-99 of the present invention showed a slight shrinkage compared to the lead apatite with parameters of a=9.843 Å and c=7.428 Å. The volume reduction of LK-99 was 0.48%, which was calculated by inputting the value obtained by substituting the unit cell parameters of lead-apatite into the formula for the volume of a hexagonal system: V = a$^2$c sin (60°) and the unit cell parameters of LK-99.

One-dimensional electron density calculation along one crystallographic axis via the Fourier transform of the calculated structure factor was used to reveal where the stress from volume reduction of the inventive ceramic material was finally affected, that is, to determine the variation of Pb(1) positions.

The electron density was calculated along the z-direction, $\rho(c)$, based on the (00*l*) reflection intensities of XRD data using the following equation:

<Equation 1>

$$\rho(z/c) = \frac{1}{c} \sum_{l=-\infty}^{\infty} F(00l)e^{-i\left(\frac{2\pi l z}{c}\right)}$$

where *l*, F(00*l*), *c* and *z* are the order of the (00*l*) diffraction peak, the structure factor, the unit cell parameter of the c-axis, and the atomic coordinate along the z-axis, respectively.

The above equation was applied for the electron density calculation of Pb(1) along the z-direction and the x-direction, and $\rho(c)$ and $\rho(a)$, based on the (00*l*) and (*h*00) reflection intensities of the XRD data in Fig. 12.

The position of Pb(1) constituting the cylindrical column is slightly shifted from the original position by the substitution of $Cu^{2+}$ inward or outward. In the repeated triangular structure of Pb(1) of the cylindrical column, the distance between Pb(1) in one layer is decreased to 2.61815 Å, and the next layer is increased to 5.23476 Å from the original distance of 3.03340 Å. However, the distance (3.7140 Å) through the c-axis between the triangular layers of Pb(1) of LK-99 remains almost unchanged from lead-apatite (3.7153 Å).

According to the analyzed results of XPS data, the binding energies (B.E.) of Pb(2) and phosphorus were unchanged. However, the tetrahedral phosphorus splitting value between 2$_{p3/2}$ and 2$_{p1/2}$ very slightly increased from 0.68 eV to 0.69 eV, and all oxygens B.E. were quite a bit increased by 0.21 eV, 0.33 eV, and 0.56 eV, respectively. Also, the B.E. value of Pb(1) was slightly decreased by 0.03 eV. From the results described above, it can be seen that the volume reduction was caused by the replacement of $Cu^{2+}$ ions, and the stress caused by the volume reduction caused the position change of Pb(1) and the binding energy change between oxygen atoms adjacent to Pb(1).

[Table 1]

| | Pb 4f$_{7/2}$, 4f$_{5/2}$ | P 2P$_{3/2}$ 2P$_{1/2}$ | O 1s | Cu 2P$_{3/2}$ 2P$_{1/2}$ |
|---|---|---|---|---|
| Lead Apati te | Pb(1) 137.42 eV<br>142.3 eV<br>Pb(2) 138.07 eV<br>142.95 eV | 131.61 eV<br>132.3 eV<br>Splitting value:<br>0.69 eV | O(4) 529.10 eV<br>O(1) 529.57 eV<br>O(2) 530.02 eV<br>O(3) 530.60 eV | |

(continued)

|  | Pb $4f_{7/2}$, $4f_{5/2}$ | P $2P_{3/2}$ $2P_{1/2}$ | O 1s | Cu $2P_{3/2}$ $2P_{1/2}$ |
|---|---|---|---|---|
| LK-9 9 | Pb(1) 137.39 eV<br>142.27 eV<br>Pb(2) 138.07 eV<br>142.94 eV | 131.62 eV<br>132.3 eV<br>Splitting value:<br>0.68 eV | O(4) 529.31 eV<br>O(1) 529.9 eV<br>O(2) 530.58 eV<br>O(3) 531.49 eV | Cu(0) 932.05 eV<br>951.91 eV<br>Cu(II) 933.78 eV<br>954.03 eV |
| Table 1 shows the binding energies of lead-apatite and LK-99. | | | | |

Experimental Example 4 - Measurement of electron paramagnetic resonance (EPR) spectroscopy

EPR Spectroscopy was performed over the temperature range from 3.45 K to 295 K using a JES-FA200 ESR X-band spectrometer (Jeol, Japan). The incident microwave power was 0.9980 mW, 20 the receiver gain was 100, and the sweep time was 1 min. The modulated magnetic field was 10 G at 100 KHz and the swept external magnetic field was -100-9,900 Oe or 0 Oe-10,000 Oe.

The powder sample prepared in Example 2 was set in a 5 mm quartz tube (Wilmad LabGlass, USA), sealed vacuum ($5 \times 10^{-5}$ torr) for LK-99 before I-V measurement. And then the sealed quartz tube was loaded into a cylinder cavity equipped with a liquid helium cryostat system.

The sample was loaded with some pieces of the sample whose electrical properties had been measured and its EPR signal was measured, not sealed vacuum after I-V measurement.

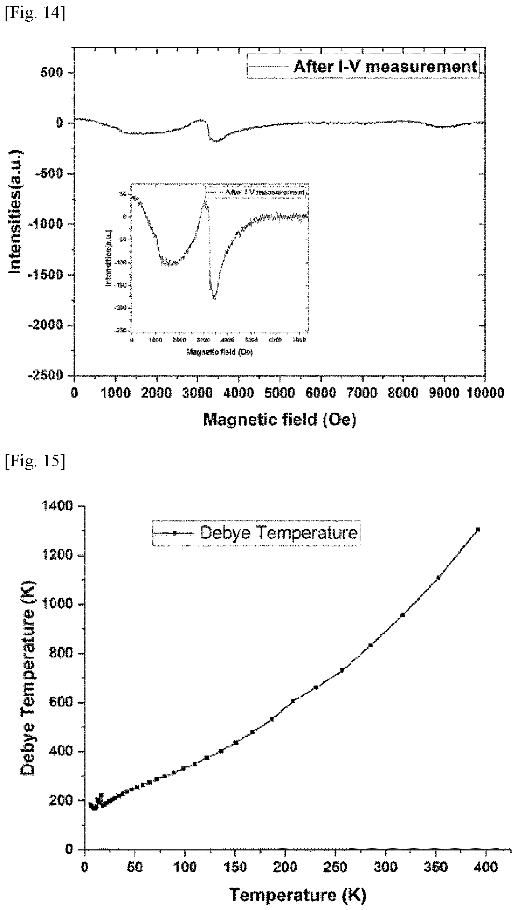

The phenomenon of superconductivity in LK-99 of the present invention can be explained by the formation of superconducting quantum wells based on the EPR test results. Fig. 13 shows an EPR signal of LK-99 according to the present invention and Fig. 14 shows an EPR signal of LK-99 after I-V measurement. The superconductivity of LK-99 will be described with reference to Figs. 13 and 14.

The EPR signal shown in Fig. 13 is the same as the heterojunction quantum well such as Si/SiGe, natural DNA in a dry state, and $\alpha$-Fe$_2$O$_3$ doped with Mg$^{2+}$. The EPR signals were interpreted as a cyclotron resonance signal of 2-dimensional electron gas (2-DEG) of quantum well, which also confirmed the creation of quantum wells in the interface between Pb(1) and phosphate of LK-99.

In addition, the EPR signals of the inventive ceramic material appeared at 3000 Oe by the substituted Cu$^{2+}$ ions, which is similar to the superconductivity of the 2-DEG system of GaAs/AlGaAs and DNA reported at 0.3 K and 1 K and the superconductivity of the superconductor having interface structure like a heterojunction of the 2-DEG system such as LaAlO$_3$/SrTiO$_3$.

Hence, it is confirmed that the superconducting quantum well (SQW) was generated between Pb(1) and oxygens of phosphate by molecular structural distortion of the inventive ceramic material. The predicted SQW band diagram is illustrated in Fig. 2.

The superconductivity of LK-99 is closely related to the formation of superconducting quantum wells (SQWs). Other electrical properties of SQWs in LK-99 appear to be associated with the very low Fermi energy of Pb(1) (-9.47 eV) and the large band gap of an insulator (5-7 eV), seem to contribute to increasing the oxygen B.E., strengthening the polarization of the insulating layer, and decreasing the B.E. of Pb(1), and are judged to contribute to lowering the Fermi energy of Pb(1).

Compared to the EPR signal in which no current was applied (Fig. 13), the overall signal intensities decreased, and the signal intensity of cyclotron resonance was relatively decreased in the EPR signal in which current was applied (Fig. 14).

As a result, from the viewpoint of SQWs, it can be judged that LK-99 with no charge reservoir for SQW supply should have partially filled SQWs. The reason for this is that the EPR signal of LK-99 can be detected as a cyclotron resonance signal but complete filling of SQWs makes it impossible to detect the cyclotron resonance signal.

However, the absorption signal appeared at a very low temperature and below 1000 Oe external magnetic field (R. Janes, R. S. Liu, P. P. Edwards, A. D. Stevens, M. C. R. Symons, Magnetic-Field Dependent Microwave-Absorption in High-Tc Superconducting Cuprates J Chem Soc Faraday T87, 1209-1215 (1991), M. Puri et al., Microwave-Absorption Characterization of the Yba2cu3o7-Delta High-Temperature Superconductor Prepared by Different Sintering and Oxygen Annealing Times. J Chem Soc Faraday T87, 167-174 (1991)), as confirmed in YBCO and Bi2212. The signal below 1000 Oe external magnetic field can be interpreted as a signal by superconducting electrons.

Experimental Example 5 - Measurement of heat capacity

The heat capacity data were collected from 5 K to 400 K with 65.26 mg of the sample prepared in Example 2 by using a physical property measurement system (PPMS, Quantum Design, USA). The raw data was calibrated with heat capacity references of $Cu_2S$ bulk and nanosheet, which is included in a small amount as an impurity.

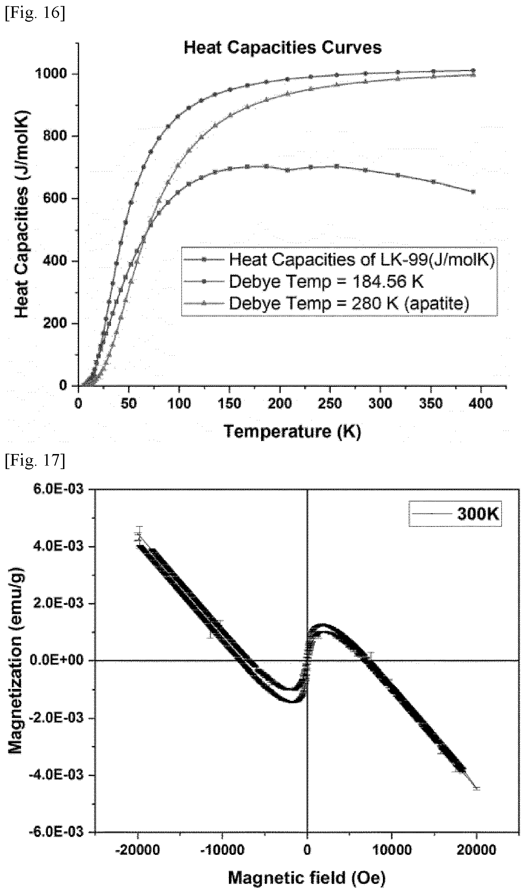

Fig. 15 shows calculated Debye temperatures from heat capacity data and Fig. 16 shows heat capacity curves of LK-99 according to the present invention.

Debye temperature was calculated based on the heat capacity data using $Pb_{10-x}Cu_x(PO_4)_6O$ formula (x = 1) through the following Debye heat capacity equation:

<Equation 2>

$$C_v = 9rNk\frac{T^3}{\theta^3}\int_0^{\theta/T}\frac{x^4 e^x dx}{(e^x - 1)^2}$$

where $C_v$ is heat capacity, $r$ is the number of atoms per molecule, $N$ is the number of molecules, $k$ is the Boltzmann constant, $T$ is the measurement temperature, $\theta$ is the Debye temperature, $x$ is $\theta/T$, and $e$ is the natural constant.

Referring to Fig. 15, the Debye temperature of LK-99 according to the present invention was constantly changing from about 184 K to 1300 K. Thus, the transition temperature (Tc) cannot be calculated with the electron-phonon prediction models.

That is, since the Debye model is a model that uses phonons to estimate the specific heat of a crystal, this prediction model cannot be used to interpret the ceramic material of the present invention, making it difficult to apply an electron-phonon model.

The heat capacity data for the ceramic material of the present invention does not show any change in second-order phase transition, which is observed in ordinary superconductors, in the temperature range from 5 K to 400 K and does not follow the law of heat capacity change by a Debye model. Therefore, the ceramic material of the present invention is considered a material that shows heat capacity data reflecting changes in its internal structural and exhibits heat capacity data for room-temperature and ambient-pressure superconductors.

In Fig. 16, the blue line curve (Debye temperature = 280 K) is the calculated heat capacity of the typical apatite because the Debye temperature of the typical apatite is 280 K and the red line curve is the calculated heat capacity results based on Debye temperature (184.56 K) at a low temperature (5 K) of LK-99, showing that the heat capacity curve (black line curve) of LK-99 does not follow the Debye models because the normal vibrational mode is limited by $Cu^{2+}$ ions replacement in the network part of LK-99 that is characterized by its molecular structure. This result also confirms that LK-99 has a structure distorted by the substitution of $Cu^{2+}$ ions.

Experimental Example 6 - Measurement of magnetic susceptibility

Magnetic susceptibility measurement was performed with VSM mode from - 20,000 G to +20,000 G at 300 K by using a superconducting quantum interference device (SQUID) or magnetic property measurement system (MPMS, Quantum Design, USA). 45.814 mg of the sample was used for this measurement.

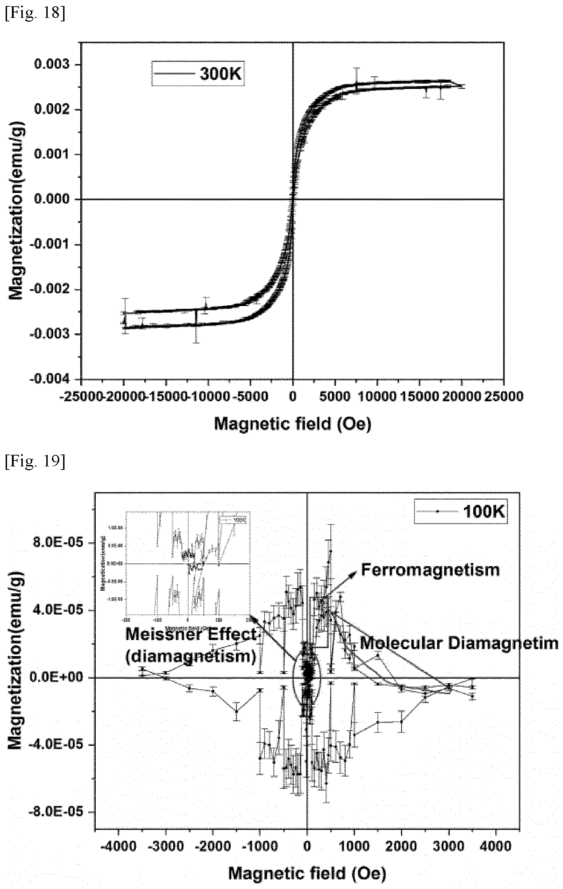

As shown in Figs. 17 and 18, LK-99 of the present invention showed ferromagnetic behaviors, which were measured with SQUID in VSM mode at 300 K (calibration to reflect the molecular diamagnetism shown in Fig. 17 leads to Fig. 18).

Experimental Example 7 - Measurement of magnetic susceptibility

Magnetic susceptibility measurement was performed with DC mode from -3,500 G to +3,500 G at 100 K by using a superconducting quantum interference device. 45.814 mg of the sample was used for this measurement.

Fig. 19 shows the Meissner effect (around 0 Oe, < ±100 Oe) and ferromagnetic (< ±500 Oe) and diamagnetic (> ±500 Oe) behaviors that were determined by DC magnetic field measurements at 100 K.

That is, the diamagnetism of the inventive ceramic material was determined by the magnetic field-dependent magnetic susceptibility of the ceramic material in the low magnetic field range (0-±50 G). Thereafter, the inventive ceramic material showed ferromagnetism in the magnetic field range of ~±50 G to ±500 G and diamagnetism (molecular diamagnetism) in the magnetic field range of ±500 G to ±3500 G.

Quantum wells with a 2-dimensional electron gas (2-DEG) system such as $\alpha$-$Fe_2O_3$ doped with $Mg^{2+}$ and natural DNA showed an antiferromagnetic or ferromagnetic behavior. The superconductivity with the 2-DEG system of GaAs/AlGaAs and DNA was reported at 0.3 K and 1 K. The superconductor having interface structure like a heterojunction of the 2-DEG system such as $LaAlO_3/SrTiO_3$ has also shown both superconductivity and magnetism. LK-99 of the present invention likewise appears to be a system that exhibit both ferromagnetism and superconductivity.

Experimental Example 8 - Measurement of electron paramagnetic resonance (EPR) spectroscopy

EPR signals were detected while applying 1 mW of microwave (~9.4 GHz) with a modulated AC magnetic field of 100 KHz and allowing a current of 200 mA-100 mA to flow through the sample at 0 G.

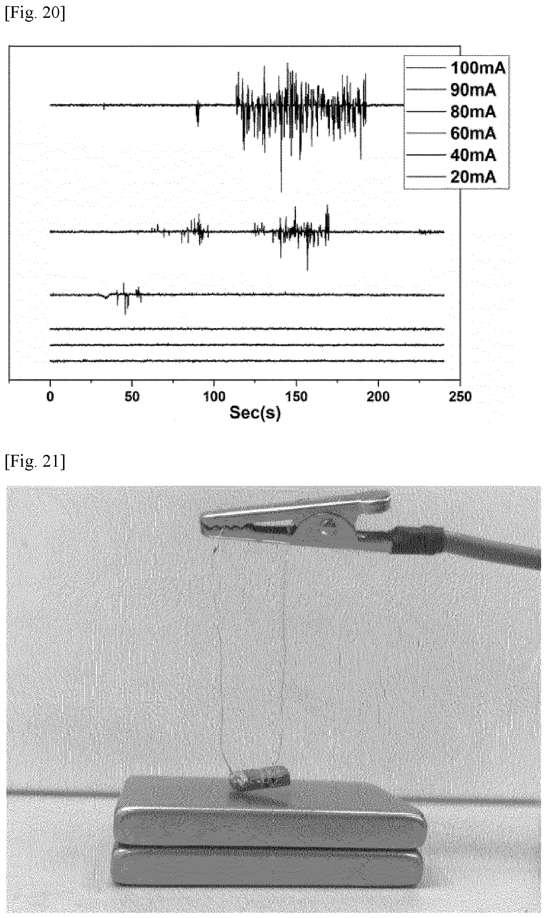

Absorption signals were detected with an electron spin resonance spectrometer at 0 G while increasing the amount of current supplied to LK-99 and are shown in Fig. 20. The supply of a larger amount of current led to larger absorption signals.

Microwave absorption at 0 G is known to be a characteristic of superconductors. Thus, the larger signal measured at a fixed magnetic field of 0 G indicates the formation of more Cooper pairs that exhibit superconductivity.

This can be interpreted as indicating that electrons are converted into superconducting electrons by a current supplied from the superconducting quantum well system of LK-99 to achieve more absorption.

Experimental Example 9 - Measurement of controllable magnetic levitation

Wires were connected to the sample of Example 2, the sample was placed on a magnet, and the phenomena of magnetic levitation generated when no current flowed and when current flowed were captured as moving images.

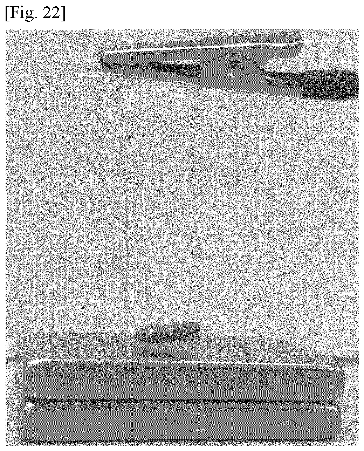

Fig. 21 shows a state in which the LK-99 sample was simply placed on a magnet because the phenomenon of magnetic levitation did not occur well when no current was supplied to the LK-99 sample, resulting in very small diamagnetism. Fig. 22 shows the occurrence of the phenomenon of magnetic levitation of the sample due to the increased number of Cooper pairs generated when current was supplied to the sample, resulting in enhanced diamagnetism.

Consequently, the reason why LK-99 of the present invention exhibits superconductivity at room temperature and ambient pressure is because the stress generated by the $Cu^{2+}$ replacement of $Pb(2)^{2+}$ ion was not relieved due to the structural uniqueness of LK-99 and at the same time was appropriately transferred to the interface of the cylindrical column.

In other words, the Pb(1) atoms in the cylindrical column interface of LK-99 occupy a structurally limited space. These atoms are entirely affected by the stress and strain generated by $Cu^{2+}$ ions. Therefore, SQWs can be generated in the interface by an appropriate amount of distortion at room temperature and ambient pressure without a relaxation.

From this point of view, the stress due to volume contraction by temperature and pressure is relieved and disappeared in CuO- and Fe-based superconductor systems because the relaxation process cannot be limited due to the structural freedom. Therefore, they need an appropriate temperature or pressure to limit the structural freedom and to achieve the SQW generation.

**Industrial applicability**

The superconductivity of the ceramic material according to the present invention has been demonstrated with a partially filled SQW model. The ceramic material of the present invention will be a very useful material for the study of superconductivity puzzles at room temperature. All evidence and explanation lead that LK-99 is the first room-temperature and ambient-pressure superconductor. LK-99 can be said to have many possibilities for various applications such as magnets, motors, cables, levitation trains, power cables, qubits for quantum computers, and THz antennas.

**Claims**

**1.**   A superconducting ceramic represented by Formula 1:

<Formula 1>         $A_{10-x}B_x(PO_4)_6O$

wherein **A** is Ca, Ba, Sr, Sn or Pb, **B** is Cu, Cd, Zn, Mn, Fe, Ni or Ag, and **x** is 0.1 to 2.0.

**2.**   The superconducting ceramic according to claim 1, wherein, in Formula 1, **B** substitutes **A.**

**3.**   The superconducting ceramic according to claim 2, wherein other **A** positions are changed by **B.**

**4.**   The superconducting ceramic according to claim 2, wherein the lattice structure of the ceramic material is modified by the substitution of **B.**

**5.**   The superconducting ceramic according to claim 2, wherein superconducting quantum wells (SQWs) are formed between **A** and $(PO_4)_6$.

6. The superconducting ceramic according to claim 5, wherein the superconducting quantum wells (SQWs) are formed at 3.7 to 6.5 Å intervals.

7. The superconducting ceramic according to claim 5, wherein tunneling occurs between the superconducting quantum wells (SQWs).

8. The superconducting ceramic according to claim 2, wherein the substitution of **B** leads to less change in heat capacity.

9. A method for producing a superconducting ceramic represented by Formula 1:

<Formula 1>    $A_{10-x}B_x(PO_4)_6O$

wherein **A** is Ca, Ba, Sr, Sn or Pb, **B** is Cu, Cd, Zn, Mn, Fe, Ni or Ag, and **x** is 0.1 to 2.0, the method comprising depositing raw materials.

10. The method according to claim 9, wherein the deposition is performed at a reaction temperature of 550 to 2000 °C.

11. A method for producing a superconducting ceramic represented by Formula 1:

<Formula 1>    $A_{10-x}B_x(PO_4)_6O$

wherein **A** is Ca, Ba, Sr, Sn or Pb, **B** is Cu, Cd, Zn, Mn, Fe, Ni or Ag, and **x** is 0.1 to 2.0, the method comprising reacting lanarkite (L, $Pb_2SO_5$=PbO·$PbSO_4$) with copper phosphide (CusP).

12. The method according to claim 11, wherein the reaction is carried out at a temperature of 600 to 1000 °C.

13. The method according to claim 11, wherein the lanarkite is prepared by weighing PbO and $PbSO_4$ to have its composition, mixing the weighed raw materials, and heating the mixture.

14. The method according to claim 11, wherein the CusP is synthesized by weighing Cu and P to have its composition, mixing the weighed raw materials, and heating the mixture.

15. A superconducting ceramic produced by the method according to any one of claims 9 to 14.

16. The superconducting ceramic according to claim 15, wherein the diamagnetism of the ceramic material is determined by the temperature-dependent magnetic susceptibility of the ceramic material.

17. The superconducting ceramic according to claim 12, wherein the diamagnetism or ferromagnetism of the ceramic material is determined by the magnetic field-dependent magnetic susceptibility of the ceramic material.

18. The superconducting ceramic according to claim 12, wherein the temperature-dependent current-voltage characteristics of the ceramic material do not follow the Ohm's law (V = I×R where V: voltage, I: current, and R: resistance).

19. The superconducting ceramic according to claim 12, wherein the current-voltage characteristics of the ceramic material optionally depend on a magnetic field (V = I×R or V ≠ I×R).

20. The superconducting ceramic according to claim 12, wherein the resistance-temperature characteristics of the ceramic material follow the Ohm's law above the transition temperature of the ceramic material.

21. The superconducting ceramic according to claim 12, wherein the heat capacity of the ceramic material does not follow the law of heat capacity change by a Debye model.

[Fig. 1]

[Fig. 2]

Pb(2)

Pb(1)

Phosphate

Channel oxygen
(1/4 occupied)

SQW

[Fig. 3]

[Fig. 4]

[Fig. 5]

[Fig. 6]

[Fig. 7]

[Fig. 8]

[Fig. 9]

[Fig. 10]

[Fig. 11]

[Fig. 12]

[Fig. 13]

[Fig. 14]

[Fig. 15]

[Fig. 16]

Heat Capacities Curves

[Fig. 17]

[Fig. 18]

[Fig. 19]

[Fig. 20]

[Fig. 21]

[Fig. 22]

<div align="center">

**INTERNATIONAL SEARCH REPORT**

</div>

| | International application No. |
|---|---|
| | **PCT/KR2022/012774** |

**A. CLASSIFICATION OF SUBJECT MATTER**

**H01L 39/12**(2006.01)i; **H01L 39/24**(2006.01)i; **C04B 35/447**(2006.01)i; **C04B 35/547**(2006.01)i; **C23C 14/06**(2006.01)i; **C23C 16/30**(2006.01)i

According to International Patent Classification (IPC) or to both national classification and IPC

**B. FIELDS SEARCHED**

Minimum documentation searched (classification system followed by classification symbols)

H01L 39/12(2006.01); B01J 35/02(2006.01); C04B 35/44(2006.01); C04B 35/505(2006.01); H01L 39/24(2006.01); H01L 41/08(2006.01); H01L 41/107(2006.01); H01M 10/0562(2010.01); H01M 4/04(2006.01); H01M 4/36(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 세라믹 (ceramic), 초전도체 (superconductor), 상온 (ordinary temperature), 상압 (ordinary pressure), 화합물 (compound)

**C. DOCUMENTS CONSIDERED TO BE RELEVANT**

| Category* | Citation of document, with indication, where appropriate, of the relevant passages | Relevant to claim No. |
|---|---|---|
| A | US 2021-0159537 A1 (CYNTEE CO., LTD.) 27 May 2021 (2021-05-27)<br>See paragraphs [0026]-[0038]. | 1-21 |
| A | US 2019-0058105 A1 (PAIS, Salvatore Cezar) 21 February 2019 (2019-02-21)<br>See claims 1-8. | 1-21 |
| A | JP 6308507 B2 (NATIONAL INSTITUTE FOR MATERIALS SCIENCE) 11 April 2018 (2018-04-11)<br>See paragraphs [0024]-[0052]. | 1-21 |
| A | JP 2021-075408 A (SEIKO EPSON CORP.) 20 May 2021 (2021-05-20)<br>See claims 1-7. | 1-21 |
| A | KR 10-2021-0050177 A (KOREA ELECTRIC POWER CORPORATION et al.) 07 May 2021 (2021-05-07)<br>See paragraphs [0028]-[0061]. | 1-21 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 January 2023** | **06 January 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

International application No.

**PCT/KR2022/012774**

| Patent document cited in search report | | | Publication date (day/month/year) | Patent family member(s) | | | Publication date (day/month/year) |
|---|---|---|---|---|---|---|---|
| US | 2021-0159537 | A1 | 27 May 2021 | CN | 112864455 | A | 28 May 2021 |
| | | | | TW | 202125877 | A | 01 July 2021 |
| US | 2019-0058105 | A1 | 21 February 2019 | US | 2019-0348597 | A1 | 14 November 2019 |
| JP | 6308507 | B2 | 11 April 2018 | EP | 3178785 | A1 | 14 June 2017 |
| | | | | EP | 3178785 | B1 | 23 October 2019 |
| | | | | US | 10431823 | B2 | 01 October 2019 |
| | | | | US | 2017-0263932 | A1 | 14 September 2017 |
| | | | | WO | 2016-021483 | A1 | 11 February 2016 |
| JP | 2021-075408 | A | 20 May 2021 | CN | 112778011 | A | 11 May 2021 |
| | | | | US | 2021-0130240 | A1 | 06 May 2021 |
| KR | 10-2021-0050177 | A | 07 May 2021 | | None | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BEDNORZ et al.** *ZPhys B,* 1986, vol. 64, 189
- **WU et al.** *Phys Rev Lett,* 1987, vol. 58, 908
- Conventional superconductivity at 203 kelvin at high pressures in the sulfur hydride system. *Nature,* 2015, vol. 525, 73
- **Y. WANG.** Fundamental Elements of Applied Superconductivity in Electrical Engineering. Wiley, 2013
- **J. W. EKIN.** Experimental Techniques for Low-Temperature Measurements. Oxford University Press, 2006

- **R. JANES ; R. S. LIU ; P. P. EDWARDS ; A. D. STEVENS ; M. C. R. SYMONS.** Magnetic-Field Dependent Microwave-Absorption in High-Tc Superconducting Cuprates. *J Chem Soc Faraday,* 1991, vol. T87, 1209-1215
- **M. PURI et al.** Microwave-Absorption Characterization of the Yba2cu3o7-Delta High-Temperature Superconductor Prepared by Different Sintering and Oxygen Annealing Times. *J Chem Soc Faraday,* 1991, vol. T87, 167-174